Europäisches Patentamt

European Patent Office

Office européen des brevets

(11) Publication number: **0 436 100 A2**

# EUROPEAN PATENT APPLICATION

(21) Application number: 90122083.0

(51) Int. Cl.5: **H04R 3/00, H04S 7/00**

(22) Date of filing: **19.11.90**

(30) Priority: **05.01.90 JP 285/90**

(43) Date of publication of application:
**10.07.91 Bulletin 91/28**

(84) Designated Contracting States:
**DE FR GB**

(71) Applicant: **PIONEER ELECTRONIC
CORPORATION
No. 4-1, Meguro 1-chome
Meguro-ku Tokyo 153(JP)**

(72) Inventor: **Tsukada, Kazuya, c/o Pioneer
Electric Corp.
Ohmori Kojo, 15-5, Ohmori Nishi 4-chome
Ohta-ku, Tokyo 143(JP)**
Inventor: **Sugiyama, Shinji, c/o Pioneer
Electric Corp.
Ohmori Kojo, 15-5, Ohmori Nishi 4-chome
Ohta-ku, Tokyo 143(JP)**

Inventor: **Kawabata, Yoshihiro, c/o Pioneer
Electric Corp.
Ohmori Kojo, 15-5, Ohmori Nishi 4-chome
Ohta-ku, Tokyo 143(JP)**
Inventor: **Kuroiwa, Takehiko, c/o Pioneer
Electric Corp.
Ohmori Kojo, 15-5, Ohmori Nishi 4-chome
Ohta-ku, Tokyo 143(JP)**
Inventor: **Arai, Naoyuku, c/o Pioneer Electric
Corp.
Ohmori Kojo, 15-5, Ohmori Nishi 4-chome
Ohta-ku, Tokyo 143(JP)**
Inventor: **Ishikawa, Kikuo, c/o Pioneer Electric
Corp.
Ohmori Kojo, 15-5, Ohmori Nishi 4-chome
Ohta-ku, Tokyo 143(JP)**

(74) Representative: **Reinhard, Skuhra, Weise
Friedrichstrasse 31
W-8000 München 40(DE)**

(54) Method for controlling audio-visual equipment and apparatus therefor.

(57) A method of and apparatus for controlling audio-visual equipment having a plurality of program sources. The method comprises the step of operating one of a plurality of preset keys. Each of the preset keys is associated with the storage of mode information about one audio-visual program source, mode information about a preamplifier, information about sound volume and other relevant audio-visual information. Selectively operating one preset key applies power to the equipment and causes it to function in accordance with the stored information associated with the key.

FIG. 1

# METHOD FOR CONTROLLING AUDIO-VISUAL EQUIPMENT AND APPARATUS THEREFOR

## BACKGROUND OF THE INVENTION

### Field of the Invention

The present invention relates to a method of and apparatus for controlling audio-visual equipment comprising a plurality of audio-visual program sources and, more particularly, to a method whereby simply operating a function changeover switch of the equipment selects and activates one of the audio-visual program sources such as a tuner, tape recorder, compact disc player, video disc player and videotape recorder for optimum appreciation.

### Description of the Prior Art

When one of the above-mentioned multiple audio-visual program sources is to be conventionally selected on the typical prior art audio-visual equipment, one way to do this is to follow a certain sequence of manual operations: turning on the power switch, operating the function switch to select the desired program source, operating the key associated with the program source to activate it, and making adjustments of such parameters as sound volume, sound quality, picture quality and sound field. Another conventional way to select one of the multiple audio-visual program sources is to set on a preset key the audio-visual state in effect before the power switch is turned off. By this method, after the power switch is turned on, the corresponding preset key is operated to restore the previously stored audio-visual state available from the desired program source.

With the above-described prior art audio-visual equipment, one disadvantage of the former method is that the power switch must be first turned on before other switches may be operated one after another. The multiple-stage operation procedure is complicated, and it takes time for the listener/viewer to start appreciating the program from the source. One disadvantage of the latter method is that although the complicated sequence of key operations is eliminated thanks to the preset key arrangement for automatically restoring the previously stored state of the desired program source, it is still necessary to turn on the power switch before operating the preset key. That is, a two-stage key operation is required.

## SUMMARY OF THE INVENTION

It is therefore an object of the present invention to provide a method of and apparatus for controlling audio-visual equipment whereby the flick of a single key allows the user to select a desired program source and to enter a desired mode in which to control the equipment.

In achieving the foregoing and other objects of the present invention and according to one aspect thereof, there is provided a method for controlling audio-visual equipment, the method comprising the step of operating one of a plurality of preset keys, each of the preset keys being associated with the storage of mode information about one audio-visual program source, mode information about a preamplifier, sound volume information and other relevant audio-visual information, wherein selectively operating one preset key applies power to the equipment and caused it to function in accordance with the stored information associated with the key.

According to another aspect of the invention, there is provided a method for controlling audio-visual equipment, the method comprising operating one of a plurality of operation keys, each of the operation keys being associated with the stored audio-visual state of one program source in terms of sound quality, "surround" option and sound volume, wherein operating one operation key applies power to the equipment without the use of a power switch and causes the equipment to function in the above state associated with the key.

## BRIEF DESCRIPTION OF THE DRAWINGS

Fig. 1 is a block diagram of a preferred embodiment of the present invention; and

Fig. 2 is a flowchart describing how the embodiment of Fig. 1 works.

## DESCRIPTION OF THE PREFERRED EMBODIMENT

The preferred embodiment of the present invention will how be described with reference to the accompanying drawings.

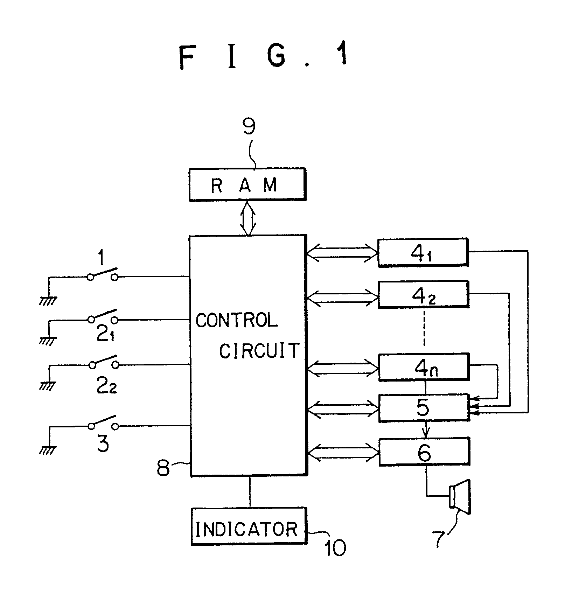

In Fig. 1, a memory switch 1 is provided in conjunction with a main amplifier or any other given piece of audio-visual equipment. Preset keys $2_1$ and $2_2$ may be supplemented by more preset keys. A function switch 3 is used to select a program source to be descried later. Audio program sources $4_1$ - $4_n$ include a tuner, tape recorder and compact disc player. A preamplifier 5 receives reproduction signals from the program sources $4_1$ - $4_n$. A main amplifier 6 amplifies the signal from the pre-amplifier 5 to drive a speaker 7.

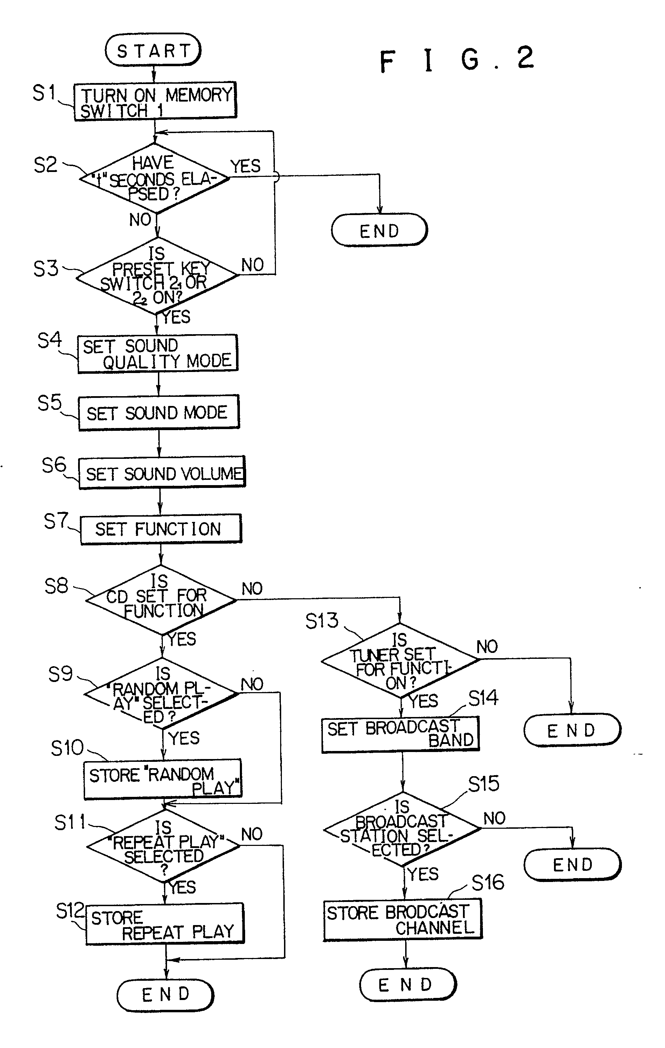

A control circuit 8 performs the operations described in the flowchart of Fig. 2. A RAM 9 stores various pieces of information coming from the control circuit 8. An indicator 10 provides such indications as time, mode and channel.

The control circuit 8 receives mode information from the program sources $4_1$ - $4_n$ (information about whether "random play" option, "repeat play" option, music serial number, subcode-compatible play option and remaining time indication if the source is a compact disk player; information about whether FM broadcastor option, AM broadcast option if the source is a tuner); mode information coming from the preamplifier 5 (a information about sound quality, "surround"option , sound field effect, function, etc.); and sound volume and output terminal option information from the main amplifier 6. The mode information described above is stored in the RAM 9. When the control circuit 8 outputs signals according to the information from the RAM 9, these signals set the program sources $4_1$ - $4_n$, preamplifier 5 and main amplifier 6 in terms of their mode.

There will now be described how the above-described construction works with reference to the flowchart of Fig. 2. In step S1, the memory switch 1 is operated. In response, the control circuit 8 checks in step S2 to see if a period of "t" seconds (e.g., 5 seconds) has elapsed. If no operation is carried out within "t" seconds of the operation of the memory switch 1, the storage process comes to an end. During the "t" second period, a check is made in step S3 to see if any of the preset keys $2_1$ and $2_2$ is operated. If the preset key $2_1$ or $2_2$ is operated during that period, the control circuit 8 goes to step S4 and asks the user to set the sound quality mode. That is, the user is asked to set the scund quality suitable for the piece of music or the program source to be selected. After the sound quality mode is set, the control circuit 8 enters step S5 and asks the user to set the "surround" mode. That is, the user is asked to turn on or off the "surround" option. After the setting of the "surround" mode, the control circuit 8 goes to step S6 and asks the user to set the sound volume. The user operates the sound volume dial to set a desired level of sound volume. The control circuit 8 then asks the user in step S7 to set the function. That is, the user is asked to select a desired program source out of the sources $4_1$ - $4_n$ using the function switch 3.

In step S8, the control circuit 8 checks to see if the compact disc player was set for the function in step S7. Where the compact disc player has been selected, the control circuit 8 checks in step S9 to see if the "random play" option is selected. With the "random play" option selected, the control circuit 8 stores the "random play" option in step S10. If the "random play" option is not selected, the control circuit 8 skips step S10 and enters step S11. In step S11, a check is made to see if the "repeat play" option is selected. With the "repeat play" option selected, the control circuit 8 stores the "repeat play" option in step S12, and completes the entire storage process. If the "repeat play" option is not selected, the control circuit 8 skips step S12 and completes the whole storage process there.

If the compact disc player is not set for the function in step S8, the control circuit 8 goes to step S13 and checks to see if the tuner is selected. If the tuner is not selected, the entire storage process comes to an end. If the tuner is selected in step S13, the control circuit 8 asks the user in step S14 to set the AM or FM. After the setting of the band option, the control circuit 8 enters step S15 and checks to see if any broadcast channel is already set. If there is any previously set broadcast channel, the control circuit 8 stores that channel in step S16, and completes the entire steps.

If the user wants to select a program source other than the compact disc player or tuner in step S7, that source may be selected in an additional step following step S7 by use of the function switch.

What happens when one preset key, $2_1$ or $2_2$, is operated to select one of the program sources $4_1$ - $4_n$, is as follows: Operating the preset key turns on power, retrieves from the RAM 9 the information about the selected program source so as to set up that source, and activates the main amplifier 6 by bringing it into the state stored in the RAM 9.

As described, each of the operation key is associated with the storage of one studio state comprising necessary parameters. Operating a desired operation key applied power to the audio equipment without the use of a power switch and causes the equipment to function with the sound quality, "surround" option and sound volume set for the program source. Thus the simple flick of a key switch initiates the audio experience desired for each program source selected, and the operability of the equipment is substantially improved accordingly.

It is to be noted that, while in the aforementioned embodiment, the invention is applied to audio equipment, this invention can also be applied to visual equipment. In such a case, a tuner, video disc player and videotape recorder are included in a visual equipment as visual program sources. Further, channel number is applied as mode information when the source is a tuner; "mute" or "auto blend" mode information, and visual mode information about color, tint and brightness is applied when a TV set is selected as the program source. Operating a desired operation key applies power to the visual equipment without the use of a power switch and causes the equipment to function with the stored information.

It is to be understood that while the invention has been described in conjunction with a specific embodiment, it is evident that many alternatives, modifications and variations will become apparent to those skilled in the art in light of the foregoing description. Accordingly, it is intended that the present invention embrace all such alternatives, modifications and variations as fall within the spirit and scope of the appended claims.

## Claims

1. A method for controlling audio equipment, said method comprising the steps of operating one of a plurality of preset keys, each of said preset keys being associated with storage of mode information about an audio program source, mode information about a preamplifier, information about sound volume and other relevant audio information; and selectively operating one preset key to apply power to said equipment and to cause it to function in accordance with the stored information associated with said key.

2. A method for controlling visual equipment, said method comprising the steps of operating one of a plurality of preset keys, each of said preset keys being associated with storage of mode information about a visual program source, mode information about a preamplifier, information about color, brightness and other relevant visual information; and selectively operating one preset key to apply power to said equipment and to cause it to function in accordance with the stored information associated with said key.

3. A method for controlling audio equipment as claimed in claim 1, wherein said audio program source includes a compact disc player, one of said preset keys is associated with storage of mode information such as random play and repeat play, and when the preset key of said compact disc player is selected, said compact disc player is switched on to function in accordance with the stored information associated with the key.

4. A method for controlling audio or visual equipment as claimed in claim 1 or 2, wherein said program source includes a tuner, one of said preset keys is associated with storage of mode information such as sound volume and band option, and when the preset key of said tuner is selected, said tuner is switched on to function in accordance with the stored information associated with said key.

5. Audio equipment control apparatus comprising:
   a function switch for selecting a program source;
   a preamplifier for receiving reproduction signals from said program source;
   a main amplifier for amplifying input signals from said preamplifier to drive a speaker;
   a memory switch;
   a plurality of preset switches being associated with storage of mode information about an audio program source, mode information about a preamplifier, information about sound volume and other relevant audio information;
   a control circuit for receiving information from said program source, said preamplifier and said main amplifier, and for setting said mode information to output control signals to said program source; and
   memory means for storing said information from said control circuit.

6. Visual equipment control apparatus comprising:
   a function switch for selecting a program source;
   a preamplifier for receiving reproduct signals from said program source;
   a main amplifier for amplifying input signals from said preamplifier to drive a speaker;
   a memory switch;
   a plurality of preset switches being associated with storage of mode information about a visual program source, mode information about a preamplifier, information about sound volume and other relevant visual information;
   a control circuit for receiving information from said program source, said preamplifier and said main amplifier, and for setting said mode information to output control signals to said program source; and
   memory means for storing said information from said control circuit.

7. Audio equipment control apparatus as claimed in claim 5, wherein compact disc player control means is provided, said compact disc player control means is applied for storing mode information such as random play and repeat play, and when a preset key of said compact disc player is selected, said compact disc player is switched on to function in accordance with the stored information associated with said key.

8. Audio or visual equipment control apparatus claimed in claim 5 or 6, where in tuner control means is provided, said tuner control means is applied for storing mode information such as band option and broadcast channel, and when a preset key of said tuner is selected, said tuner is switched on to function in accordance with the stored information associated with said key.

# F I G . 1

# F I G . 2

START

S1 — TURN ON MEMORY SWITCH 1

S2 — HAVE "t" SECONDS ELAPSED ? — YES → END

NO ↓

S3 — IS PRESET KEY SWITCH 2₁ OR 2₂ ON? — NO → (to END)

YES ↓

S4 — SET SOUND QUALITY MODE

S5 — SET SOUND MODE

S6 — SET SOUND VOLUME

S7 — SET FUNCTION

S8 — IS CD SET FOR FUNCTION — NO →

S13 — IS TUNER SET FOR FUNCTION ? — NO → END

YES ↓

S9 — IS "RANDOM PLAY" SELECTED ? — NO →

YES ↓

S10 — STORE "RANDOM PLAY"

S11 — IS "REPEAT PLAY" SELECTED ? — NO →

YES ↓

S12 — STORE REPEAT PLAY

END

S14 — SET BROADCAST BAND

S15 — IS BROADCAST STATION SELECTED ? — NO → END

YES ↓

S16 — STORE BRODCAST CHANNEL

END